# EUROPEAN PATENT APPLICATION

(11) **EP 2 117 024 A2**
(43) Date of publication of application: **11.11.2009**
(21) Application number: 09157960.7
(22) Date of filing: 15.04.2009
(51) Int. Cl.: H01H 13/06, H05K 3/28

(54) **Waterproof method for electronic device and waterproof electronic device**

(30) Priority: 08.05.2008 TW 97116979; 07.04.2009 US 419514
(71) Applicant: Qbas Co., Ltd., Taipei (TW)
(72) Inventor: Shiue, Jason, Taipei (TW)
(74) Representative: Viering, Jentschura & Partner

(57) **Abstract**

A waterproof method for an electronic device (3) and a waterproof electronic device (3) are provided. The electronic device comprises a printed circuit board (20), which comprises a board (21), a plurality of electrical elements (23) and a button device (29). The waterproof method comprises the following steps: applying a first non-solid adhesive to cover the button device directly, curing the first non-solid adhesive to form a first waterproof layer (27a), applying a second non-solid adhesive to at least cover the electrical elements directly and curing the second non-solid adhesive to form a second waterproof layer (27b). In the end, assembling the printed circuit board, sealed with the waterproof layers, into a case to form the waterproof electronic device.

## Description

This application claims priority to Taiwan Patent Application No. 097116979 filed on May 8, 2008 and US Patent Application No. 12/419,514 filed on April 7, 2009, which is the continuation-in-part application of US Patent Application 12/168,609, filed on July 7, 2008. The disclosure of US Patent Application No. 12/419,514 is incorporated by reference herein in its entirety.

### CROSS-REFERENCES TO RELATED APPLICATIONS

Not applicable.

### BACKGROUND OF THE INVENTION

### Field of the Invention

The present invention relates to a waterproof method, and in more particular, to a waterproof method for an electronic device.

### Descriptions of the Related Art

The continuous improvement of living standards has imposed increasingly heightened requirements on how to maintain the physical fitness and improve the quality of life. During activities such as jogging or bicycling that may make people feel insipid due to the monotonic actions or tedious environment, people often carry MP3 music players for entertainment. Over recent years, water sports such as swimming and diving have also become more popular. As a result, a challenge arises when swimmers and divers would like to use MP3 music players for entertainment. That is, the electric devices should be able to operate normally in water without incurring a short-circuit problem.

Due to their structural limitations and physical characteristics, common electronic devices are not waterproof and, hence, can not be used directly in water. Because of this, it is impossible for people to carry or use music players, digital cameras or other electronic devices when engaging in water sports. To solve this problem, a waterproof housing is provided for conventional electronic devices by disposing waterproof gaskets at the seams of the electronic devices' housing or to put the electronic device directly into a waterproof housing. This will prevent moisture from making contact with electronic components within the electronic device to cause a short-circuit problem and even cause damage to the electronic device.

However, the aforesaid waterproof gaskets are generally made of rubber materials, which cause the joining surfaces to be worn out after the waterproof housing has been opened and closed for many times. Furthermore, under a large water pressure, moisture is still likely to seep into the waterproof housing, causing damage to the electronic device. Consequently, the conventional waterproof housing fails to make electronic devices waterproof completely and effectively. On the other hand, use of the waterproof housing further adds to the overall weight, volume and cost of the electronic devices, which makes them inconvenient for use and reduces the consumers' willingness to buy such electronic devices.

Accordingly, efforts still have to be made in the art to provide a waterproof method that is capable of making electronic devices effectively waterproof and will reduce the weight, volume and cost thereof.

### SUMMARY OF THE INVENTION

One objective of this invention is to provide a waterproof method for an electronic device, which is capable of making electronic devices effectively waterproof and will reduce the weight, volume and cost thereof. The electronic device comprises a circuit board, which further comprises a board, a plurality of electrical elements and a button device. The electrical elements and the button device are disposed on the board. To this end, the waterproof method of this invention comprises the following steps: (a) applying a first non-solid adhesive to cover the button device directly; (b) solidifying the first non-solid adhesive to form a first waterproof layer; (c) applying a second non-solid adhesive to at least cover the electrical elements directly; and (d) solidifying the second non-solid adhesive to form a second waterproof layer. Therefore, the first non-solid adhesive and the second non-solid adhesive may be selected from different materials or be formulated to have proper material properties according to the practical use thereof, and are applied respectively in sequence. Preferably, the first non-solid adhesive is more flexible than the second non-solid adhesive, so that the first waterproof layer solidified from the first non-solid adhesive exhibits an appropriate elasticity to allow the button device to be pressed smoothly and to work normally.

Another objective of this invention is to provide a waterproof electronic device, which is effectively waterproof and has a reduced weight, volume and cost. To this end, the waterproof electronic device of this invention comprises a housing, a circuit board, a first waterproof layer and a second waterproof layer. The housing is permeable to water and defines a receiving space. The circuit board is disposed in the receiving space, and comprises a board, a plurality of electrical elements disposed on the board, and a button device disposed on the board. The first waterproof layer is solidified from a first non-solid adhesive and covers the button device directly. The second waterproof layer is solidified from a second non-solid adhesive and at least covers the electrical elements directly. Therefore, the first non-solid adhesive and the second non-solid adhesive may be selected from different materials or be formulated to have proper material properties according to the practical use thereof, and are applied respectively in sequence. Preferably, the first non-solid adhesive is more flexible than the second non-solid adhesive so that the first waterproof layer is provided with an appropriate elasticity to allow the button device to be pressed smoothly and to work normally.

The detailed technology and preferred embodiments implemented for the subject invention are described in the following paragraphs accompanying the appended drawings for people skilled in this field to well appreciate the features of the claimed invention.

### BRIEF DESCRIPTION OF THE DRAWINGS

**FIG. 1** is a flowchart of a waterproof method for an electronic device of this invention;
**FIG. 2A** is a perspective view of a circuit board of this invention formed with a first waterproof layer;
**FIG. 2B** is a perspective view of the circuit board of this invention formed with a second waterproof layer;
**FIG. 2C** is a partial cross-sectional view taken along line **A-A** in **FIG. 2B****;**
**FIG. 2D** is a perspective view of the circuit board of this invention when disposed in a mould;
**FIG. 3A** is an exploded view of the waterproof electronic device of this invention;
**FIG. 3B** is a perspective view of the waterproof electronic device of this invention; and
**FIG. 4** is a perspective view of a diving mask with the waterproof electronic device of this invention.

### DESCRIPTION OF THE PREFERRED EMBODIMENT

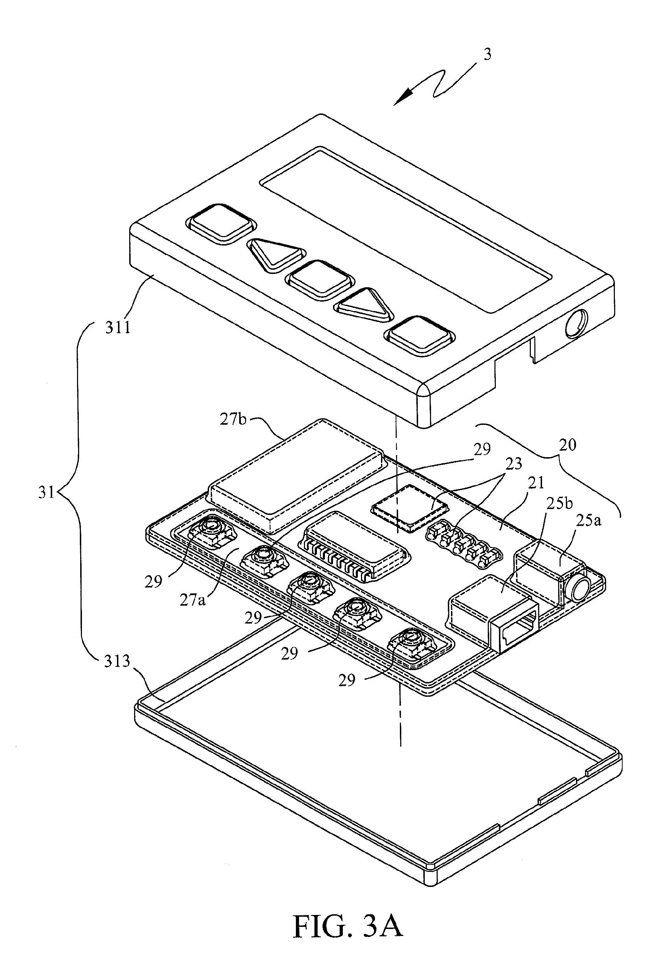

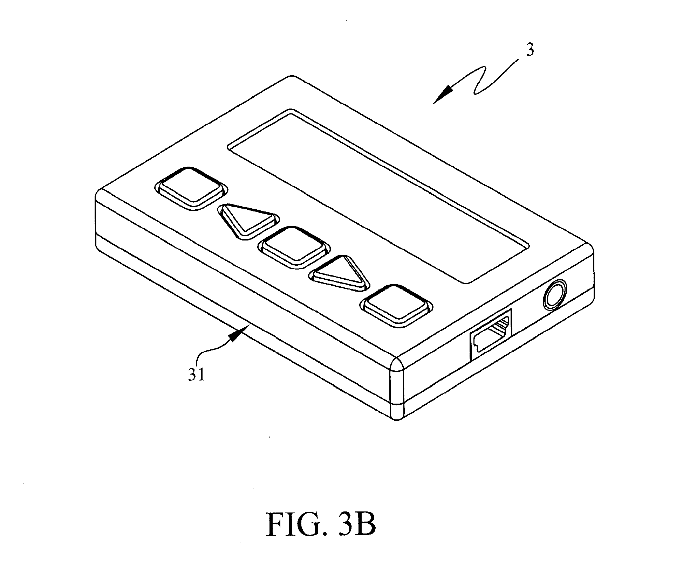

A waterproof electronic device **3** of this invention is depicted in **FIGS. 3A** and **3B****.** It should be noted herein that in consideration of the operational convenience of the waterproof electronic device **3** and the physical characteristics of non-solid adhesives, this invention applies a first non-solid adhesive and a second non-solid adhesive with different properties onto specific surfaces of the circuit board to form a first waterproof layer **27a** and a second waterproof layer **27b** with different characteristics. Furthermore, for purposes of description, elements covered by the first waterproof layer **27a** and the second waterproof layer **27b** are shown in dashed lines in the drawings. The second waterproof layer **27b** also covers the periphery of the first waterproof layer **27a,** so the periphery of the first waterproof layer **27a** is also shown in dashed lines. The electronic device **3** of this invention comprises a circuit board **20.** The circuit board **20** comprises a board **21,** a plurality of electric elements **23** and at least one button device **29.** The electric elements **23** and the button device **29** are disposed on the board **21.** According to this invention, the flexible first waterproof layer **27a** is formed to cover the button device **29** directly, while the second waterproof layer **27b** is formed to at least cover the plurality of electric elements **23** directly, making the electronic device **3** effectively waterproof and reducing the weight, volume and cost thereof. The first non-solid adhesive and the second non-solid adhesive are selected from different materials or be formulated to have proper material properties in use of the same materials with different ratios according to the practical use thereof.

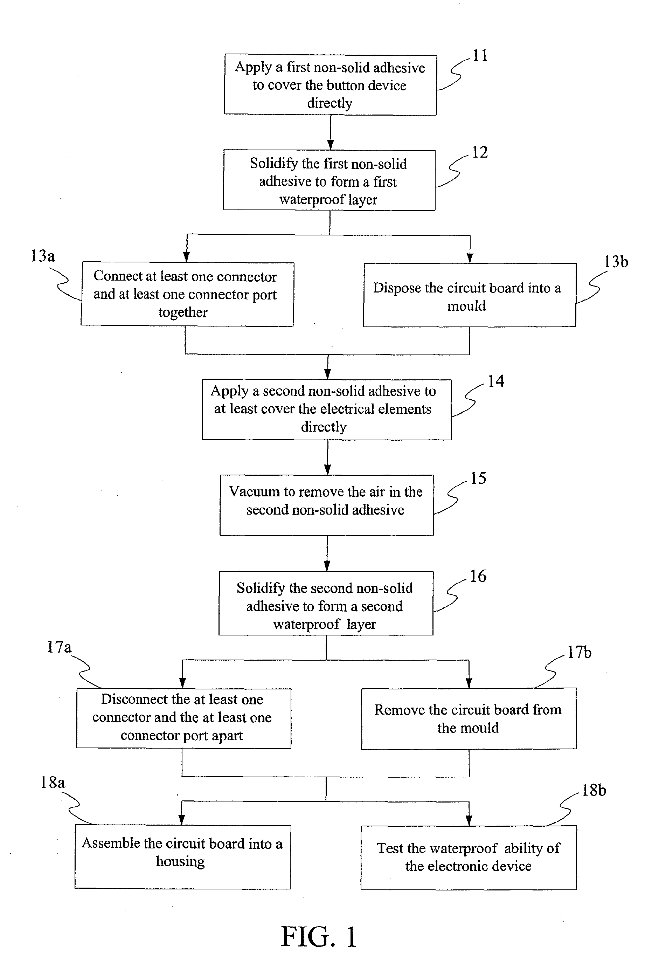

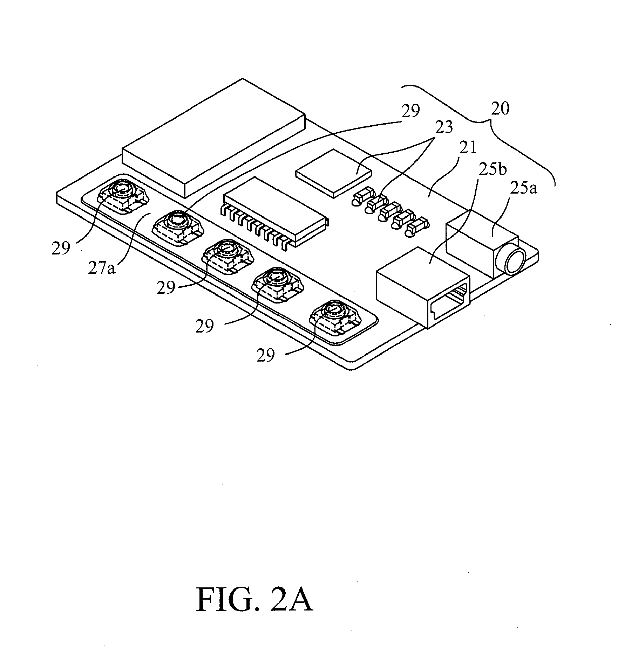

The flowchart of an embodiment of a waterproof method for the electronic device **3** according to this invention is depicted in **FIG. 1****.** With further reference to **FIG. 2A**, in step **11** shown in **FIG. 1**, a first non-solid adhesive with a high flexibility is first applied to at least directly cover a plurality of button device **29** disposed on the board **21.** The application may be accomplished by brushing the first non-solid adhesive onto the button devices **29** or pouring the first non-solid adhesive onto the button devices **29** so that the first non-solid adhesive is adhered to the button device **29** directly.

In step **12,** the first non-solid adhesive applied onto the button devices **29** is solidified to form the first waterproof layer **27a** of a high flexibility so that the button devices **29** are isolated from water. The first waterproof layer **27a** has an appropriate elasticity, so the button devices **29** can be pressed normally to serve button functions. In this embodiment, solidifying the first non-solid adhesive to form the first waterproof layer **27a** is accomplished by placing it at a normal temperature or baking it at a high temperature to shorten the time duration needed. Baking at an extremely high temperature should be prevented because it could damage the board **21** as well as the electric elements **23** and the button devices **29** disposed on the board **21.** The solidification may be performed by either of or a combination of the two solidification processes.

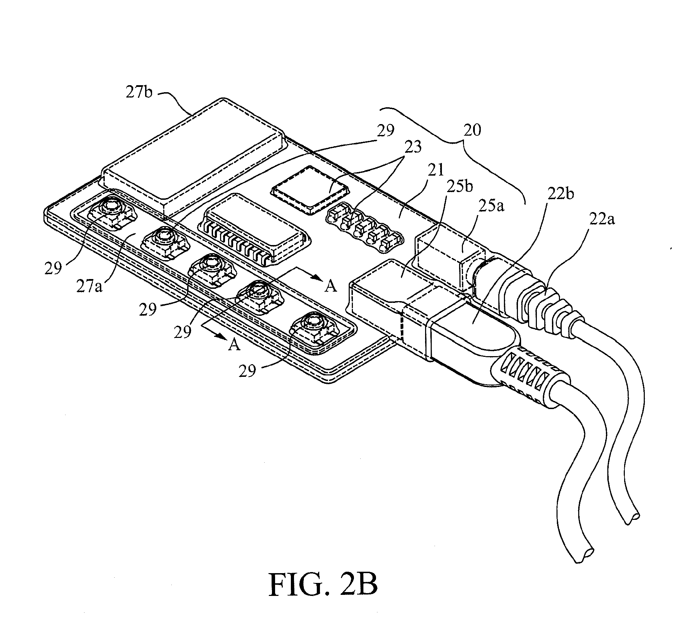

After the first waterproof layer **27a** covering the button device **29** is formed, a second non-solid adhesive is further applied. As shown in **FIG. 2B****,** in this embodiment, the electric elements **23** disposed on the board **21** further comprises at least one connector port **25a, 25b,** which is connected with at least one connector **22a, 22b** respectively to receive/transmit various signals. Hence, before applying the second non-solid adhesive in step **14,** step **13a** may be executed to connect the at least one connector **22a, 22b** with the at least one connector port **25a, 25b** to prevent the second non-solid adhesive with a lower viscosity from permeating through and covering a plurality of connector terminals (not shown) of the at least one connector port **25a, 25b** during the application process; otherwise, this would cause failure in normal signal transmissions.

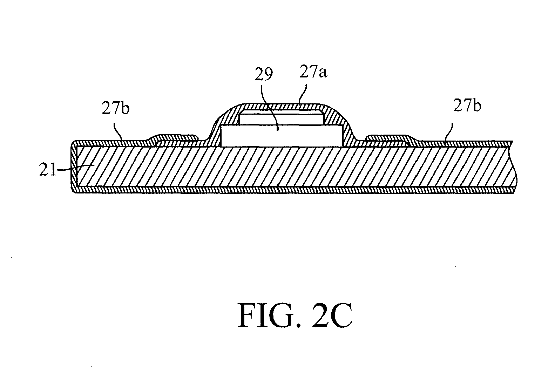

In references to both **FIGS. 1** and **2B****,** subsequent to step **13a,** step **14** is executed to apply the second non-solid adhesive to at least cover the electric elements **23** directly. In this embodiment, the second non-solid adhesive completely covers the surface of the circuit board **20** other than the button devices **29** to provide a desirable waterproof function. The first non-solid adhesive has a higher flexibility than the second non-solid adhesive to allow the button devices **29** to serve the button functions normally. On the other hand, the second non-solid adhesive has a lower viscosity than that of the first non-solid adhesive so that the second non-solid adhesive can permeate into the fine slits of the circuit board **21** to seal against water completely. However, it should be emphasized that, as shown in **FIG. 2C** (for purposes of clearer illustration, the cross-sectional line of the button devices **29** is not shown in **FIG. 2C**), the second non-solid adhesive only covers the periphery of the first waterproof layer **27a** partially and it is necessary to prevent the second non-solid adhesive from covering the first waterproof layer **27a** entirely for exposing the first waterproof layer **27a.** Because the second waterproof layer **27b** formed by the solidified second non-solid adhesive is harder than the first waterproof layer **27a** with a higher flexibility, this may prevent a harder second waterproof layer **27b** from interfering with the normal operation of the button devices **29.**

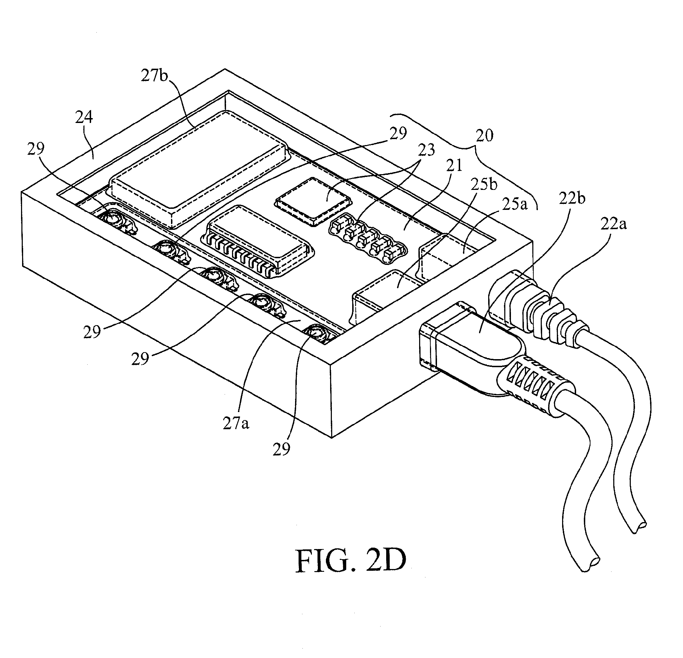

The application of the second non-solid adhesive may be accomplished by a brushing or a pouring process. However, in the preferred embodiment, the application of the second non-solid adhesive is accomplished by the pouring process. As shown in **FIG. 2D****,** if the second non-solid adhesive is applied through the pouring process, step **13b** needs to be executed before step **14** to put the circuit board **20** into a mould **24.** The mould **24** may be made of a material selected from the group consisting of polypropylene (PP), polycarbonate (PC), polyurethane (PU), acrylonitrile butadiene styrene (ABS) and nylon. In the preferred example, the application of the second non-solid adhesive is accomplished in the following way. The second non-solid adhesive with a lower viscosity is poured into the mould **24,** and through the natural flow thereof, the second non-solid adhesive is allowed to cover the surface of the plurality of electric elements **23** uniformly without entirely covering the first waterproof layer **27a.**

Next, the second non-solid adhesive is solidified to form a second waterproof layer **27b.** However, prior to step **16,** step **15** is preferably executed ahead to form a vacuum in advance. The purpose is to evacuate the air within the second non-solid adhesive so that the solidified second waterproof layer **27b** is adapted to cover the circuit board **20** more closely. Subsequent to step **15,** step **16** is executed where the second non-solid adhesive is solidified in a way similar to that of the first non-solid adhesive, and this will not be further described herein.

In other examples, in step **14,** the second non-solid adhesive may be applied only on portions of the circuit board **20** where a waterproof effect is desired, and accordingly, the second waterproof layer **27b** formed in step **16** also covers the corresponding portions of the circuit board **20.**

After the second waterproof layer **27b** is formed in step **16,** step **17a** may be executed corresponding to the aforesaid step **13a.** In step **17a,** the at least one connector **22a, 22b** is disconnected from the at least one connector port **25a, 25b** to expose the connector terminals. Through the execution of step **13a** to connect the connectors **22a, 22b** to the connector ports **25a, 25b** before the second non-solid adhesive is applied, the solidified second waterproof layer **27b** is prevented from covering the connector terminals to adversely affect signal transmissions and result in poor signal quality. In this embodiment, connector ports **25a, 25b** are an earphone jack and a USB connector port respectively, while the connectors **22a, 22b** are an earphone plug and a USB connector respectively. In other embodiments, as will be readily known by those of ordinary skill in the art, the circuit board **20** may further have other kinds and another number of connector ports that are adapted to connect with various connectors respectively.

After the second waterproof layer **27b** is formed in step **16,** step **17b** shall be executed corresponding to the aforesaid step **13b** to remove the circuit board **20,** covered with the waterproof layers **27a, 27b,** from the mould **24,** thus obtaining a circuit board **20** with a waterproof function.

It should be further noted that in the above steps, the first non-solid adhesive applied in this invention shall have a higher flexibility than the second non-solid adhesive so that the first waterproof layer **27a** resulting from solidification has an appropriate elasticity, to prevent the waterproof layer from interfering with the action of pressing the button devices **29** due to excessive hardness. Furthermore, the second non-solid adhesive shall have a lower viscosity than that of the first non-solid adhesive so that when being applied, the second non-solid adhesive can flow freely on the surface of the circuit board **20** and within gaps between the circuit board **20** and the mould **24** and permeate into all the fine slits of the circuit board **20.** In this way, the solidified second waterproof layer **27b** can fully serve the waterproof function. Therefore, because the first waterproof layer **27a** and the second waterproof layer **27b** need to be made of materials of different physical characteristics, the first non-solid adhesive of this embodiment should be made of a material comprising silicone, thermoplastics or polyurethane, while the second non-solid adhesive should be made of a material comprising epoxy.

As shown in **FIGS. 3A** and **3B****,** subsequent to the formation of the waterproof layers **27a, 27b,** step **18a** is executed to assemble the circuit board **20** to a housing **31,** which comprises an upper housing **311** and a lower housing **313,** to form the waterproof electronic device **3** of this invention. In this embodiment, by using the waterproof layers **27a, 27b,** the waterproof electronic device **3** is made to be waterproof, no matter whether the housing **31** has a waterproof function or even if a non-waterproof housing **31** is adopted deliberately in the waterproof electronic device **3** of this invention to reduce costs.

Additionally, prior to or subsequent to step **18a,** step **18b** may be executed to test if the waterproof electronic device **3** has desirable waterproof properties. In this embodiment, step **18b** places the waterproof electronic device **3** into a pressure vessel (not shown) containing water, which is then sealed and applied with an increased pressure to simulate the case of operating the waterproof electronic device **3** in water. In this embodiment, the test pressure is set to simulate a pressure that would occur at **50** meters under water and the test lasts for **30** minutes. Finally, the pressure is released and the waterproof electronic device **3** removed from the pressure vessel to inspect for any abnormal conditions and damages of the waterproof mechanism and the operation functions. The waterproof test method of this invention is not limited to the method described above. Rather, other test methods will be readily known by those of ordinary skill in the art and may also accomplish the purpose of this invention.

In references to both **FIGS. 3A** and **3B****,** the waterproof electronic device **3** of this invention formed through the above process comprises a housing **31,** a circuit board **20,** a first waterproof layer **27a** and a second waterproof layer **27b.** The housing **31** comprises an upper housing **311** and a lower housing **313,** and defines a receiving space for the circuit board **20** to be received therein. The housing **31** may be a waterproof housing; alternatively, to save costs related to the waterproof measures of the housing, the housing **31** of this invention is preferably permeable to water, i.e., is non-waterproof. The circuit board **20** comprises a board **21,** a plurality of electric elements **23** and at least one button device **29** (there are five buttons in this embodiment). The electric elements **23** and the button device **29** are all disposed on the board **21,** and the electric elements **23** comprises at least one connector port (comprises a plurality of connector ports **25a, 25b** in this embodiment). Each of the connector ports **25a, 25b** has at least one connector terminal for connection with the corresponding external connectors **22a, 22b** (as shown in **FIG. 2B**). Although only some of the electrical elements are shown by the reference numeral **23** in **FIG. 3A****,** the circuit board **20** further comprises other electrical elements. In addition, even though the connector ports **25a, 25b** are an earphone jack and a USB connector port respectively in this embodiment; in other embodiments, the circuit board **20** may further have other kinds and another number of connector ports that are adapted to connect with various connectors respectively.

The first waterproof layer **27a** is formed with the first non-solid adhesive and covers the button device **29** directly. The second waterproof layer **27b** is formed with the second non-solid adhesive and at least covers the electric elements **23** directly. The second waterproof layer **27b** covers at least one portion of the connector ports **25a, 25b** and leaves the connector terminals exposed. Additionally, as shown in **FIG. 2C****,** the second waterproof layer **27b** further covers at least one portion of the first waterproof layer **27a.** More specifically, the second waterproof layer **27b** covers the periphery of the first waterproof layer **27a** and leaves portions of the first waterproof layer **27a** corresponding to the button device **29** exposed.

It should be noted that the first non-solid adhesive has a higher flexibility than the second non-solid adhesive so that the first waterproof layer **27a** resulting from solidification has an appropriate elasticity. Through the appropriate deformation of the first waterproof layer **27a,** the user can press the button device **29** through the upper housing **311** to control the waterproof electronic device **3.** Furthermore, the second non-solid adhesive has a lower viscosity than that of the first non-solid adhesive, so the second non-solid adhesive can fully permeate into all fine slits of the circuit board **20,** thus forming a second waterproof layer **27b** that can provide an adequate waterproof effect. Therefore, according to the physical characteristics of the materials, the first non-solid adhesive is preferably made of a material comprising silicone, thermoplastics or polyurethane, while the second non-solid adhesive is preferably made of a material comprising epoxy.

In this embodiment, the second waterproof layer **27b** directly covers the board **21,** the plurality of electric elements **23** and the connector ports **25a, 25b** of the circuit board **20,** but leaves the connector terminals exposed to facilitate the subsequent connection with the connectors **22a, 22b** during use. It should be noted herein that the connector terminals within the connector ports **25a, 25b** are not covered by the second waterproof layer **27b** to prevent interference with the electrical connection between the connectors **22a, 22b** and the connector terminals.

The waterproof electronic device **3** may be a multimedia player (e.g., a MP3 player) in this embodiment; however, as will be readily appreciated by those of ordinary skill in the art, the waterproof electronic device **3** may also be any of various other electronic devices, such as a digital camera, a light emitting device, a mobile phone and so on. Furthermore, the waterproof electronic device **3** of this embodiment may not comprise the housing **31,** but may be used or disposed directly in other devices. The way in which the waterproof electronic device **3** is formed is just as described above in the embodiment of the waterproof method, and thus will not be further described herein.

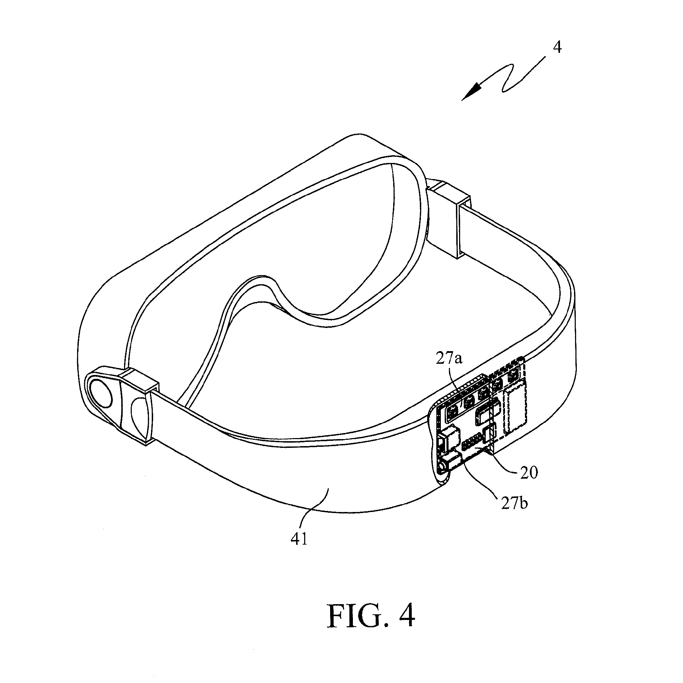

Furthermore, the waterproof electronic device of this invention may also be disposed in a strap-like structure such as a strap of a diving mask. As shown in **FIG. 4****,** the waterproof electronic device of this invention is disposed in a diving mask **4,** in which a strap **41** of the diving mask **4** is used as a housing of the waterproof electronic device. In this embodiment, the circuit board **20** covered with the waterproof layers **27a, 27b** is received in the strap **41.**

According to the above descriptions, this invention provides a waterproof method for an electronic device and a waterproof electronic device formed by the method to replace the conventional solutions of either using an additional waterproof housing or disposing a waterproof gasket in the electronic device. Thus, as compared to conventional waterproof solutions that tend to fail due to damage and are also heavy, bulky and costly, this invention makes an improvement by making the electronic device waterproof while still having a light weight, small volume and low cost. Meanwhile, waterproof layers of different properties are formed in the waterproof method of this invention, which makes the electronic device more convenient to use in practical applications.

The above disclosure is related to the detailed technical contents and inventive features thereof. People skilled in this field may proceed with a variety of modifications and replacements based on the disclosures and suggestions of the invention as described without departing from the characteristics thereof. Nevertheless, although such modifications and replacements are not fully disclosed in the above descriptions, they have substantially been covered in the following claims as appended.

## Claims

1. A waterproof method for an electronic device, in which the electronic device comprises a circuit board, the circuit board comprises a board, a plurality of electrical elements and a button device, and the electrical elements and the button device are disposed on the board, the waterproof method comprising the following steps of:
(a) applying a first non-solid adhesive to cover the button device directly;
(b) solidifying the first non-solid adhesive to form a first waterproof layer;
(c) applying a second non-solid adhesive to at least cover the electrical elements directly; and
(d) solidifying the second non-solid adhesive to form a second waterproof layer;
wherein the first non-solid adhesive is more flexible than the second non-solid adhesive.

2. The waterproof method as claimed in claim 1, wherein the step (a) is brushing the first non-solid adhesive onto the button device or pouring the first non-solid adhesive onto the button device.

3. The waterproof method as claimed in claim 1, wherein the electrical elements comprise at least one connector port, the at least one connector port has a plurality of connector terminals and matching at least one connector correspondingly, and before step (c), the waterproof method further comprising the following step of:
(e) connecting the at least one connector and the at least one connector port together to avoid the second non-solid adhesive covering the connector terminals.

4. The waterproof method as claimed in claim 3, wherein, after step (d), the waterproof method further comprises the following step of:
(f) disconnecting the at least one connector and the at least one connector port apart to expose the connector terminals.

5. The waterproof method as claimed in claim 1, wherein, before step (c), the waterproof method further comprises the following step of:
(c1) disposing the circuit board into a mould.

6. The waterproof method as claimed in claim 5, wherein step (c) is pouring the second non-solid adhesive into the mould to at least cover the electrical elements directly.

7. The waterproof method as claimed in claim 6, wherein, after step (d), the waterproof method further comprises the following step of:
(g) removing the circuit board from the mould.

8. The waterproof method as claimed in claim 1, wherein the first non-solid adhesive is made of a material comprising silicone, thermoplastics or polyurethane.

9. The waterproof method as claimed in claim 1, wherein the second non-solid adhesive has a lower viscosity than the first non-solid adhesive.

10. The waterproof method as claimed in claim 9, wherein the second non-solid adhesive is made of a material comprising epoxy.

11. A waterproof electronic device, comprising:
a housing defining a receiving space;
a circuit board disposed in the receiving space, in which the circuit board comprises:
a board;
a plurality of electrical elements disposed on the board; and
a button device disposed on the board;
a first waterproof layer formed by solidifying a first non-solid adhesive, the first waterproof layer covering the button device directly; and
a second waterproof layer formed by solidifying a second non-solid adhesive, wherein
the first non-solid adhesive is more flexible than the second non-solid adhesive, and the second waterproof layer at least covering the electrical elements directly.

12. The waterproof electronic device of claim 11, wherein the electrical elements comprise at least one connector port having a plurality of connector terminals, and the second waterproof layer covers at least one portion of the at least one connector port and exposes the connector terminals.

13. The waterproof electronic device as claimed in claim 11, wherein the second non-solid adhesive has a lower viscosity than the first non-solid adhesive.

14. The waterproof electronic device as claimed in claim 13, wherein the second waterproof layer is made of a material comprising epoxy.

15. The waterproof electronic device as claimed in claim 11, wherein the first waterproof layer is made of a material comprising silicone, thermoplastics or polyurethane.
